# EUROPEAN PATENT SPECIFICATION

(11) **EP 4 312 288 B1**
(45) Date of publication and mention of the grant of the patent: **22.04.2026**
(21) Application number: 22929218.0
(22) Date of filing: 02.06.2022
(51) Int. Cl.: H01M 4/36, H01M 4/525, H01M 4/505, H01M 4/131, H01M 4/02

(54) **LITHIUM-ION BATTERY POSITIVE ELECTRODE PLATE, LITHIUM-ION BATTERY WITH SAME, AND ELECTRICAL APPARATUS**
POSITIVELEKTRODENPLATTE FÜR LITHIUM-IONEN-BATTERIE, LITHIUM-IONEN-BATTERIE DAMIT UND ELEKTRISCHE VORRICHTUNG
PLAQUE D'ÉLECTRODE POSITIVE DE BATTERIE LITHIUM-ION, BATTERIE LITHIUM-ION DOTÉE DE CELLE-CI ET APPAREIL ÉLECTRIQUE

(43) Date of publication of application: 31.01.2024
(73) Proprietor: Contemporary Amperex Technology (Hong Kong) Limited, Central, Central And Western District (HK)
(72) Inventor: SHEN, Chongheng, Ningde Fujian 352100 (CN); HUAN, Shuxing, Ningde Fujian 352100 (CN); LUO, Dongsheng, Ningde Fujian 352100 (CN); WANG, Bangrun, Ningde Fujian 352100 (CN); WU, Qi, Ningde Fujian 352100 (CN); CHEN, Qiang, Ningde Fujian 352100 (CN); LIU, Na, Ningde Fujian 352100 (CN)
(74) Representative: Gong, Jinping
(86) International application number: PCT/CN2022/096833
(87) International publication number: WO 2023/230985

(56) References cited:
- WO-A1-2022/047705
- CN-A- 102 447 107
- CN-A- 108 431 998
- CN-A- 110 098 403
- CN-A- 111 384 372
- CN-A- 113 921 782
- KR-A- 20210 080 249
- US-A1- 2007 099 087
- US-A1- 2021 313 563

## Description

### Technical Field

The present application relates to the technical field of lithium batteries, and in particular to a lithium-ion battery positive electrode plate, a lithium-ion battery with the same, and an electrical apparatus.

### Background Art

In recent years, with the increasingly wide use of lithium-ion batteries, lithium-ion batteries are widely used in energy storage power systems such as water power, thermal power, wind power and solar power stations, as well as electric tools, electric bicycles, electric motorcycles, electric vehicles, military equipment, aerospace and other fields. Due to the great development of lithium-ion batteries, higher requirements have also been put forward for their energy density, processability and the like.

There is still a gap between compacted density of a positive electrode active material and its ultimate compacted density in the existing lithium-ion battery positive electrode plate. If the compacted density of the positive electrode plate is increased simply by increasing the roller pressure, elongation of the electrode plate may be excessive at a high active material load. Excessive elongation of the electrode plate can easily lead to problems such as brittle fracture of the electrode plate during winding or hot pressing. Therefore, it is still necessary to develop positive electrode plates for lithium-ion batteries with a low elongation and a high compacted density under a high active material load.

WO2022047705A1 describes a positive electrode material comprising lithium iron phosphate single crystal particles and lithium iron phosphate secondary particles.

KR20210080249A describes a positive electrode active material layer comprising: a first positive electrode active material layer comprising a first positive electrode active material and a second positive electrode active material; and a second positive electrode active material layer comprising a third positive electrode active material.

US2021313563A1 describes a cathode active material layer comprising a first particle and a second particle, the first particle comprising a secondary particle composed of a third particle.

CN108431998A describes a positive electrode comprising a first active material particle, a second active material particle, and a third active material particle.

CN111384372A describes a positive electrode material including lithium nickel transition metal oxide A and lithium nickel transition metal oxide B.

### Summary of the Invention

The present application is carried out in view of the above subject and intended to provide a lithium-ion battery positive electrode plate as defined in claims 1 to 11, a lithium-ion battery as defined in claim 12, a battery module as defined in claim 13, a battery pack as defined in claim 14 and an electrical apparatus as defined in claim 15, which achieves a high compacted density at a low elongation under a high active material load.

In order to achieve the above objective, a first aspect of the present application provides a lithium-ion battery positive electrode plate, which comprises a positive electrode current collector and a positive electrode film layer disposed on at least one surface of the positive electrode current collector, wherein the positive electrode film layer comprises a positive electrode active material mixture composed of the following materials:
polycrystalline particles of a first positive electrode active material with a particle size of 11.0-20.0 µm;
polycrystalline particles of a second positive electrode active material with a particle size of 6.0-10.5 µm; and
monocrystalline particles of a third positive electrode active material with a particle size of 1.1-5.2 µm;
wherein the number of the polycrystalline particles of the first positive electrode active material is a, the number of the polycrystalline particles of the second positive electrode active material is b, the number of the monocrystalline particles of the third positive electrode active material is c, and (a+b):c is in the range of 5.7:4.3 to 7.7:2.3.

In this way, according to the present application, three types of positive electrode active materials with different particle sizes are combined in a specific ratio, so that the positive electrode plate can still achieve a high compacted density at a low elongation under a high positive electrode material load.

In any of embodiments, (a+b):c is in the range of 6.1:3.9 to 7.2:2.8. By further selecting the number ratio of the three types of positive electrode active material particles, the compacted density of the positive electrode plate can be further improved.

In any of embodiments, the polycrystalline particles of the first positive electrode active material, the polycrystalline particles of the second positive electrode active material and the monocrystalline particles of the third positive electrode active material are all ternary positive electrode active materials, optionally, the polycrystalline particles of the first positive electrode active material, the polycrystalline particles of the second positive electrode active material and the monocrystalline particles of the third positive electrode active material each have the same or different chemical composition and all have the chemical formula LiNiₐCo_{b}M_{(1-a-b)}O₂, where 0.8 ≤ a < 1.0, 0 < b < 0.2, and a + b < 1.0, and M is selected from one or more of Mn, Al, B, Zr, Sr, Y, Sb, W, Ti, Mg and Nb. The selection of the ternary materials as the positive electrode active materials and the selection of the specific chemical composition are conducive to obtaining high gram capacity and initial coulombic efficiency and long battery cycle life.

In any of embodiments, pore volume of the positive electrode film layer is in the range of 1.2 mm³/g to 4.0 mm³/g. By controlling the pore volume of the positive electrode film layer, it is possible to ensure that the positive electrode plate has a high compacted density at a low elongation.

In any of embodiments, a shear stress of the positive electrode plate is in the range of 0.65 MPa to 0.85 MPa. It is ensured that such a positive electrode plate can achieve better toughness and is less prone to brittle fracture after being elongated under a high rolling pressure.

In any of embodiments, in the positive electrode active material mixture, the polycrystalline particles of the first positive electrode active material have a Dv50 of 12-16 µm and a total mass of A; the polycrystalline particles of the second positive electrode active material have a Dv50 of 8-10 µm and a total mass of B; the monocrystalline particles of the third positive electrode active material have a Dv50 of 2.5-4 µm and a total mass of C; and (A+B):C is in the range of 6:4 to 8:2, optionally in the range of 6.5:3.5 to 7.5:2.5. By controlling the mass ratio of these three positive electrode active material particles, it is possible to ensure that the positive electrode plate has a high compacted density at a low elongation.

In any of embodiments, compacted density CPD-1T of the positive electrode active material mixture under 1 ton of pressure is in the range of 3.0g/cm³ to 3.2g/cm³. By controlling the compacted density of the positive electrode active material mixture under 1 ton of pressure within the above range, it is possible to ensure that the positive electrode plate has a high compacted density at a low elongation.

In any of embodiments, a BET specific surface area of the positive electrode active material mixture is in the range of 0.5 m²/g to 0.7m²/g. By controlling the BET specific surface area of the positive electrode active material mixture within the above range, it is possible to ensure that the positive electrode plate has a high compacted density at a low elongation.

In any of embodiments, a SPAN value of the positive electrode active material mixture is in the range of 1.70 to 2.20, where SPAN = (Dv90-Dv10)/Dv50. By controlling the SPAN value of the positive electrode active material mixture within the above range, it is possible to ensure that the positive electrode plate has a high compacted density at a low elongation.

In any of embodiments, the positive electrode active material mixture has a Dv99 in the range of 18 µm to 21 µm. By controlling the Dv99 of the positive electrode active material mixture within the above range, it is possible to increase the compacted density of the positive electrode plate.

In any of embodiments, a SPAN value of the polycrystalline particles of the first positive electrode active material satisfies SPAN ≤ 1.20, optionally, 0.50 ≤ SPAN ≤ 1.00. By controlling the SPAN value of the polycrystalline particles of the first positive electrode active material within the above range, sufficient filling space can be provided and a high gram capacity can be provided for the positive electrode plate.

In any of embodiments, a SPAN value of the polycrystalline particles of the second positive electrode active material satisfies SPAN ≤ 1.20, optionally, 1.30 ≤ SPAN ≤ 1.50. By controlling the SPAN value of the polycrystalline particles of the second positive electrode active material within the above range, pores and spaces can be fully filled to increase the compacted density of the positive electrode plate.

In any of embodiments, a SPAN value of the monocrystalline particles of the third positive electrode active material satisfies SPAN ≤ 1.70, optionally, 1.10 ≤ SPAN ≤ 1.40. By controlling the SPAN value of the monocrystalline particles of the third positive electrode active material within the above range, a high resistance to compression can be provided for the positive electrode plate.

In any of embodiments, tap density of the monocrystalline particles of the third positive electrode active material satisfies TPD ≤ 1.8g/cm³, optionally, 1.2g/cm³ ≤ TPD ≤ 1.5g/cm³. When the tap density of the monocrystalline particles of the third positive electrode active material is within the above range, it has a highly dispersed morphology, thereby further improving the space utilization rate of the positive electrode plate and increasing the compacted density of the electrode plate.

A second aspect of the present application provides a lithium-ion battery, which comprises the positive electrode plate according to the first aspect of the present application.

A third aspect of the present application provides a battery module, which comprises the lithium-ion battery according to the second aspect of the present application.

A fourth aspect of the present application provides a battery pack, which comprises the battery module according to the third aspect of the present application.

A fifth aspect of the present application provides an electrical apparatus, which comprises at least one selected from the lithium-ion battery according to the second aspect of the present application, the battery module according to the third aspect of the present application, or the battery pack according to the fourth aspect of the present application.

### Description of Drawings

Fig. 1 is a scanning electron microscope image of a positive electrode plate according to Example 1 of the present application.
Fig. 2 is a schematic diagram of a lithium-ion battery according to an embodiment of the present application.
Fig. 3 is an exploded view of the lithium-ion battery according to an embodiment of the present application shown in Fig. 2.
Fig. 4 is a schematic diagram of a battery module according to an embodiment of the present application.
Fig. 5 is a schematic diagram of a battery pack according to an embodiment of the present application.
Fig. 6 is an exploded view of the battery pack according to an embodiment of the present application shown in Fig. 5.
Fig. 7 is a schematic diagram of an electrical apparatus where a lithium-ion battery according to an embodiment of the present application is used as a power source.

### Description of reference numerals:

1 battery pack; 2 upper box body; 3 lower box body; 4 battery module; 5 lithium-ion battery; 51 case; 52 electrode assembly; 53 top cover assembly

### Detailed Description

In the following, embodiments of a lithium-ion battery positive electrode plate, a lithium-ion battery with the same, a battery module, a battery pack and an electrical apparatus of the present application are specifically disclosed by properly referring to the detailed description of the drawings. However, there are cases where unnecessary detailed descriptions are omitted. For example, there are cases where detailed descriptions of well-known items and repeated descriptions of actually identical structures are omitted. This is to avoid unnecessary redundancy in the following descriptions and to facilitate the understanding by those skilled in the art. In addition, the drawings and subsequent descriptions are provided for those skilled in the art to fully understand the present application, and are not intended to limit the subject matter recited in the claims.

The "range" disclosed in the present application is defined in terms of lower and upper limits, and a given range is defined by selecting a lower limit and an upper limit, which define the boundaries of a particular range. A range defined in this manner may be inclusive or exclusive of end values, and may be arbitrarily combined, that is, any lower limit may be combined with any upper limit to form a range. For example, if ranges of 60-120 and 80-110 are provided for a specific parameter, it is understood that ranges of 60-110 and 80-120 can also be envisioned. Additionally, if the minimum range values 1 and 2 are listed, and if the maximum range values 3, 4 and 5 are listed, the following ranges are all contemplated: 1-3, 1-4, 1-5, 2- 3, 2-4 and 2-5. In the present application, unless stated otherwise, the numerical range "a-b" represents an abbreviated representation of any combination of real numbers between a and b, where both a and b are real numbers. For example, the numerical range "0-5" means that all real numbers between "0-5" have been listed herein, and "0-5" is just an abbreviated representation of the combination of these numerical values. Additionally, when it is stated that a certain parameter is an integer of ≥2, it is equivalent to disclosing that the parameter is, for example, an integer of 2, 3, 4, 5, 6, 7, 8, 9, 10, 11, 12, etc.

Unless otherwise specified, all embodiments and optional embodiments of the present application may be combined with each other to form new technical solutions.

Unless otherwise specified, all technical features and optional technical features of the present application may be combined with each other to form new technical solutions.

Unless otherwise specified, all steps of the present application may be performed sequentially or randomly, and preferably sequentially. For example, a method including steps (a) and (b) indicates that the method may include steps (a) and (b) performed in sequence, or may include steps (b) and (a) performed in sequence. For example, that the method may further include step (c) indicates that step (c) may be added to the method in any order. For example, the method may include steps (a), (b), and (c), or steps (a), (c), and (b), or steps (c), (a), and (b), or the like.

Unless otherwise specified, the terms "include" and "comprise" mentioned in the present application may be open-ended or closed-ended. For example, the "include" and "comprise" may indicate that it is possible to include or comprise other components not listed, and it is also possible to include or comprise only the listed components.

Unless otherwise specified, the term "or" is inclusive in the present application. By way of example, the phrase "A or B" means "A, B, or both A and B". More specifically, the condition "A or B" is satisfied under any one of the following conditions: A is true (or present) and B is false (or absent); A is false (or absent) and B is true (or present); or both A and B are true (or present).

High battery cell mass and volumetric energy density can be achieved by increasing gram capacity of a positive electrode active material on the one hand, and increasing compacted density of a positive electrode plate under a high active material load on the other hand. However, if the compacted density of the positive electrode plate is increased simply by increasing the roller pressure, the positive electrode active material is prone to particle crushing and particle slippage, resulting in a large elongation in length direction of the positive electrode plate, for example, an elongation greater than or equal to 0.8%. Excessive elongation of the electrode plate can easily lead to problems such as brittle fracture of the electrode plate during winding or hot pressing. Therefore, it is still necessary to develop positive electrode plates for lithium-ion batteries with a low elongation and a high compacted density under a high active material load.

The inventors of the present application have found that when polycrystalline particles of two types of positive electrode active materials in a specific particle size range are mixed with monocrystalline particles of a positive electrode active material in a specific particle size range as a positive electrode active material in a specific ratio, the resulting positive electrode plate can achieve a high compacted density at a low elongation.

"Monocrystalline" and "polycrystalline" described in the present application have common meanings in the technical field of positive electrode active materials. Generally speaking, polycrystalline particles of a positive electrode active material refer to quasi-spherical aggregates formed by accumulation of a large number of small crystal grains, and monocrystalline particles of a positive electrode active material refer to monomers or quasi-agglomerates formed by small grains with clear boundaries, either individually or in groups. "Monocrystalline" and "polycrystalline" can be confirmed by methods well known in the art, such as observing the particle morphology by a scanning electron microscope.

In an embodiment of the present application, the present application provides a lithium-ion battery positive electrode plate, including a positive electrode current collector and a positive electrode film layer disposed on at least one surface of the positive electrode current collector, wherein the positive electrode film layer comprises a positive electrode active material composed of the following materials:
polycrystalline particles of a first positive electrode active material with a particle size of 11.0-20.0 µm;
polycrystalline particles of a second positive electrode active material with a particle size of 6.0-10.5 µm; and
monocrystalline particles of a third positive electrode active material with a particle size of 1.1-5.2 µm;
wherein the number of the polycrystalline particles of the first positive electrode active material is a, the number of the polycrystalline particles of the second positive electrode active material is b, the number of the monocrystalline particles of the third positive electrode active material is c, and (a+b):c is in the range of 5.7:4.3 to 7.7:2.3.

In the present application, the particle size refers to a distance between two farthest points of a particle in a scanning electron microscope (SEM) photograph. The particle size can be tested using devices and methods known in the art. For example, a scanning electron microscope (for example, ZEISS Sigma 300) is used, with reference to JY/T010-1996, to obtain a scanning electron microscope (SEM) photograph of the positive electrode plate.

In the present application, the number of one type of particles is determined by randomly selecting 10 regions on the positive electrode plate and taking SEM photographs of each region separately, and counting the number of the particles that meet the particle size range in each test region through the SEM photographs, and calculating an average value of the number of the particles in each test region.

Although the mechanism is not yet clear, the applicants unexpectedly found that by combining two types of polycrystalline positive electrode active materials with different particle sizes and one monocrystalline positive electrode active material in a specific ratio, it is possible to sufficiently increase the utilization rate of pores and volumes between the particles and to increase compressive capacity of the positive electrode plate. Therefore, the positive electrode plate can still achieve a high compacted density at a low elongation under a high positive electrode active material load. Without being confined to theory, it is now considered that the polycrystalline particles of the first positive electrode active material with a particle size of 11.0-20.0 µm are used as a skeleton of the positive electrode film layer, where too large a particle size is prone to cracking at edges of the particles and may limit the extractable gram capacity, while too small a particle size may not act as a skeleton. The polycrystalline particles of the second positive electrode active material with a particle size of 6.0-10.5 µm are used as a primary filler, which improves space utilization rate and improves the extractable gram capacity. The monocrystalline particles of the third positive electrode active material with a particle size of 1.1-5.2 µm are used as a secondary filler, due to its high dispersion and compression resistance, it can fully fill pores left by the polycrystalline particles of the first positive electrode active material and the polycrystalline particles of the second positive electrode active material. Moreover, setting the number ratio of (a+b):c in the range of 5.7:4.3 to 7.7:2.3 can maximize the balance between the gram capacity and the compacted density, such compacted accumulation makes it less prone to particle shift/slippage under high pressure, thereby avoiding a great elongation of the electrode plate that leads to an increase of brittleness. If the above ratio is too small, the battery capacity will be affected, and if the ratio is too large, it will be difficult to improve the compacted density.

In some embodiments, (a+b):c is in the range of 6.1:3.9 to 7.2:2.8, such as 6.2:3.8. By further selecting the number ratio of the three types of positive electrode active material particles, the compacted density of the positive electrode plate can be further improved.

The ratio of the number a of the polycrystalline particles of the first positive electrode active material to the number b of the polycrystalline particles of the second positive electrode active material can be optionally selected by those skilled in the art according to actual needs, for example, a:b may be in the range of 1:9 to 7.5:2.5.

The polycrystalline particles of the first positive electrode active material, the polycrystalline particles of the second positive electrode active material and the single-crystalline particles of the third positive electrode active material may have the chemical compositions of conventional positive electrode active materials in the art. As an example, the positive electrode active material may include at least one of the following materials: lithium-containing phosphate with olivine structure, lithium transition metal oxide, and their respective modified compounds. However, the present application is not limited to these materials, and other conventional materials useful as positive electrode active materials for batteries can also be used. It is possible to use only one of these positive electrode active materials alone, or to use more than two in combination. Here, examples of the lithium transition metal oxide may include, but are not limited to, at least one of a lithium-cobalt oxide (such as LiCoO₂), lithium-nickel oxide (such as LiNiO₂), lithium-manganese oxide (such as LiMnO₂ and LiMn₂O₄), lithium-nickel-cobalt oxide, lithium-manganese-cobalt oxide, lithium-nickel-manganese oxide, lithium-nickel-cobalt-manganese oxide (such as LiNi_{1/3}Co_{1/3}Mn_{1/3}O₂ (also abbreviated as NCM₃₃₃), LiNi_{0.5}Co_{0.2}Mn_{0.3}O₂ (also abbreviated as NCM₅₂₃), LiNi_{0.5}Co_{0.25}Mn_{0.25}O₂ (also abbreviated as NCM₂₁₁), LiNi_{0.6}Co_{0.2}Mn_{0.2}O₂ (also abbreviated as NCM₆₂₂), LiNi_{0.8}Co_{0.1}Mn_{0.1}O₂ (also abbreviated as NCM₈₁₁)), lithium-nickel-cobalt-aluminum oxide (such as LiNi_{0.85}Co_{0.15}Al_{0.05}O₂) and their respective modified compounds. Examples of the lithium-containing phosphate with olivine structure may include, but are not limited to, at least one of lithium iron phosphate (such as LiFePO₄ (also abbreviated as LFP)), lithium iron phosphate-carbon composite, lithium manganese phosphate (such as LiMnPO₄), lithium manganese phosphate-carbon composite, lithium manganese iron phosphate, and lithium manganese iron phosphate-carbon composite.

In some embodiments, the polycrystalline particles of the first positive electrode active material, the polycrystalline particles of the second positive electrode active material and the monocrystalline particles of the third positive electrode active material are all ternary positive electrode active materials, optionally, the polycrystalline particles of the first positive electrode active material, the polycrystalline particles of the second positive electrode active material and the monocrystalline particles of the third positive electrode active material each have the same or different chemical composition and all have the chemical formula LiNiₐCo_{b}M_{(1-a-b)}O₂, where 0.8 ≤ a < 1.0, 0 < b < 0.2, and a + b < 1.0, and M is selected from one or more of Mn, Al, B, Zr, Sr, Y, Sb, W, Ti, Mg and Nb. The selection of the ternary materials as the positive electrode active materials and the selection of the specific chemical composition are conducive to obtaining high gram capacity and initial coulombic efficiency and long battery cycle life.

In some embodiments, pore volume of the positive electrode film layer is in the range of 1.2 mm³/g to 4.0 mm³/g, optionally, in the range of 1.2 mm³/g to 2.0 mm³/g. By controlling the pore volume of the positive electrode film layer, it is possible to ensure that the positive electrode plate has a high compacted density at a low elongation.

The pore volume has a meaning well known in the art. In the present application, the pore volume of the positive electrode film layer may be tested by methods well known in the art. As an example, reference may be made to GB/T 21650.2-2008/ISO 15901-2: 2006 "Evaluation of Pore Size Distribution and Porosity of Solid Materials by Mercury Porosimetry and Gas Adsorption", Part 2: Analysis of Mesopores and Macropores by Gas Adsorption. An AccuPyc II 1340 true density tester is used for determination.

In some embodiments, a shear stress of the positive electrode plate is in the range of 0.65 MPa to 0.85 MPa. It is ensured that such a positive electrode plate has a high tensile strength and can achieve better toughness and is less prone to brittle fracture after being elongated under a high rolling pressure.

The shear stress has a meaning well known in the art. In the present application, the shear stress is measured by the following method: cutting out a sample with a width of 0.02 m and a length of 0.1 m from an electrode plate to be tested, the edge of the sample having an exposed current collector region for welding of tabs; applying a double-sided tape with a width of 0.02 m and a length of 0.09 m to a steel plate with a width of 0.02 m and a length of 0.2 m, where one end of the double-sided tape is flush with one end of the steel plate; applying the sample to the double-sided tape with one end of the sample flush with one end of the tape; fixing a paper tape with a width of 0.02 m and a length of 0.15 m to the exposed current collector surface of the electrode plate sample; fixing the end of the steel plate that is not attached with the electrode plate by a lower fixture of a tensile machine, folding the paper tape upwards and fixing it by an upper clamp, turning on the tensile machine to stretch 180° continuously at a speed of 0.05 m/min; and recording a maximum load indicated by the tensile machine when the electrode plate breaks, and denoting it as the shear stress of the electrode plate.

In some embodiments, in the positive electrode active material mixture, the polycrystalline particles of the first positive electrode active material have a Dv50 of 12-16 µm, for example, 12-13 µm and 13-16 µm and a total mass of A; the polycrystalline particles of the second positive electrode active material have a Dv50 of 8-10 µm, for example, 8-9 µm and 9-10 µm and a total mass of B; the monocrystalline particles of the third positive electrode active material have a Dv50 of 2.5-4 µm, for example, 2.5-3 µm and 3-4 µm and a total mass of C; and (A+B):C is in the range of 6:4 to 8:2, optionally in the range of 6.5:3.5 to 7.5:2.5. By controlling the mass ratio of these three positive electrode active material particles, it is possible to ensure that the positive electrode plate has a high compacted density at a low elongation.

The ratio of the total mass A of the polycrystalline particles of the first positive electrode active material to the total mass B of the polycrystalline particles of the second positive electrode active material can be optionally selected by those skilled in the art according to practical needs, for example, A:B may be in the range of 2:8 to 7:3.

In the present application, volume-based particle size Dv50 of the positive electrode active material particles and Dv10, Dv90, and Dv99 mentioned below are well known concepts in the art. Specifically, Dv10 is a particle size at which cumulative distribution by volume of particles reaches 10% as counted from the small particle size side. Dv50 is a particle size at which cumulative distribution by volume of particles reaches 50% as counted from the small particle size side. Dv90 is a particle size at which cumulative distribution by volume of particles reaches 90% as counted from the small particle size side. Dv99 is a particle size at which cumulative distribution by volume of particles reaches 99% as counted from the small particle size side. The volume-based particle sizes Dv10, Dv50, Dv90 and Dv99 of the particles may be tested by methods well known in the art. For example, the particle sizes may be determined using an instrument Malvern 3000 in accordance with GB/T 19077-2016/ISO 13320:2009 Particle size analysis - Laser diffraction methods.

In some embodiments, compacted density CPD-1T of the positive electrode active material mixture under 1 ton of pressure is in the range of 3.0 g/cm³ to 3.2 g/cm³, optionally, in the range of 3.1 g/cm³ to 3.2 g/cm³. By controlling the compacted density of the positive electrode active material mixture under 1 ton of pressure within the above range, it is possible to ensure that the positive electrode plate has a high compacted density at a low elongation.

In the present application, the test method of the CPD-1T (Compacted Density) of the positive electrode active material mixture under 1 ton of pressure may be a method well known in the art. As an example, the compacted density may be determined using a UTM7305 electronic pressure tester in accordance with GB/T 5162-2006 "Graphite Negative Electrode Materials for Lithium-ion Batteries".

In some embodiments, a BET specific surface area of the positive electrode active material mixture is in the range of 0.5 m²/g to 0.7 m²/g, optionally, in the range of 0.59 m²/g to 0.63 m²/g. By controlling the BET specific surface area of the positive electrode active material mixture within the above range, it is possible to ensure that the positive electrode plate has a high compacted density at a low elongation.

In the present application, the specific surface area BET of the positive electrode active material may be tested by methods well known in the art. As an example, the specific surface area may be determined using an instrument TriStar II 3020 in accordance with GB/T 19587-2017 "Determination of Specific Surface Area of Solids by Gas Adsorption Using the BET Method".

In some embodiments, a SPAN value of the positive electrode active material is in the range of 1.70-2.20, where SPAN = (Dv90-Dv10)/Dv50. Optionally, the SPAN value of the positive electrode active material is in the range of 1.75 to 2.10. By controlling the SPAN value of the positive electrode active material mixture within the above range, it is possible to ensure that the positive electrode plate has a high compacted density at a low elongation.

In some embodiments, the positive electrode active material mixture has a Dv99 in the range of 18 µm to 21 µm, optionally, in the range of 19.5 µm to 21 µm. By controlling the Dv99 of the positive electrode active material mixture within the above range, it is possible to increase the compacted density of the positive electrode plate.

In some embodiments, a SPAN value of the polycrystalline particles of the first positive electrode active material satisfies SPAN ≤ 1.20, optionally, 0.50 ≤ SPAN ≤ 1.00. By controlling the SPAN value of the polycrystalline particles of the first positive electrode active material within the above range, sufficient filling space can be provided and a high gram capacity can be provided for the positive electrode plate.

In some embodiments, a SPAN value of the polycrystalline particles of the second positive electrode active material satisfies SPAN ≤ 1.20, optionally, 1.30 ≤ SPAN ≤ 1.50. By controlling the SPAN value of the polycrystalline particles of the second positive electrode active material within the above range, pores and spaces can be fully filled to increase the compacted density of the positive electrode plate.

In some embodiments, a SPAN value of the monocrystalline particles of the positive electrode active material satisfies SPAN ≤ 1.70, optionally, 1.10 ≤ SPAN ≤ 1.40. By controlling the SPAN value of the monocrystalline particles of the third positive electrode active material within the above range, a high compression resistance can be provided for the positive electrode plate, thus increasing the compacted density of the positive electrode plate.

In some embodiments, tap density of the monocrystalline particles of the third positive electrode active material satisfies TPD ≤1.8 g/cm³, optionally, 1.2 g/cm³ ≤ TPD ≤ 1.5 g/cm³. When the tap density of the monocrystalline particles of the third positive electrode active material is within the above range, it has a highly dispersed morphology, thereby further improving the space utilization rate of the positive electrode plate and increasing the compacted density of the electrode plate.

In the present application, TPD (Tap Density) of the positive electrode active material particles may be tested by methods known in the art. As an example, the tap density may be determined using a Bettersize BT-300 powder tap density tester in accordance with GB/T 24533-2009 "Metallic Powders - Determination of Tap Density".

Further, the lithium-ion battery, the battery module, the battery pack, and the electrical apparatus of the present application will be described below with reference to the drawings .

In an embodiment of the present application, provided is a lithium-ion battery.

Typically, the lithium-ion battery includes a positive electrode plate, a negative electrode plate, an electrolyte, and a separator. During the charging and discharging process of the battery, active ions are intercalated and deintercalated back and forth between the positive electrode plate and the negative electrode plate. The electrolyte serves to conduct ions between the positive electrode plate and the negative electrode plate. The separator is disposed between the positive electrode plate and the negative electrode plate, and mainly functions to prevent a short circuit between the positive electrode and the negative electrode while allowing ions to pass through.

### [Positive electrode plate]

The positive electrode plate as defined above includes a positive electrode current collector and a positive electrode film layer disposed on at least one surface of the positive electrode current collector.

As an example, the positive electrode current collector has two opposite surfaces in its own thickness direction, and the positive electrode film layer is disposed on either or both of the two opposite surfaces of the positive-electrode current collector.

In some embodiments, the positive electrode current collector can be a metal foil or a composite current collector. For example, an aluminum foil can be used as the metal foil. The composite current collector may include a high molecular material substrate layer and a metal layer formed on at least one surface of the high molecular material substrate layer. The composite current collector can be formed by forming a metal material (aluminium, aluminium alloy, nickel, nickel alloy, titanium, titanium alloy, silver and silver alloy, etc.) on a high molecular material substrate (such as polypropylene (PP), polyethylene terephthalate (PET), polybutylene terephthalate (PBT), polystyrene (PS), and polyethylene (PE)).

In some embodiments, the positive electrode film layer further optionally includes a binder. As an example, the binder may include at least one of polyvinylidene fluoride (PVDF), polytetrafluoroethylene (PTFE), a vinylidene fluoride-tetrafluoroethylene-propylene terpolymer, a vinylidene fluoride-hexafluoropropylene-tetrafluoroethylene terpolymer, a tetrafluoroethylene-hexafluoropropylene copolymer and a fluorine-containing acrylate resin.

In some embodiments, the positive electrode film layer further optionally includes a conductive agent. For example, the conductive agent may include at least one of superconducting carbon, acetylene black, carbon black, Ketjen black, carbon dot, carbon nanotubes, graphene, and carbon nanofibers.

In some embodiments, the positive electrode plate can be prepared by dispersing the components for preparing the positive electrode plate, for example, the positive electrode active material, the conductive agent, the binder and any other components in a solvent (for example, N-methyl pyrrolidone) to form a positive electrode slurry; and coating the positive electrode slurry on a positive electrode current collector, followed by oven drying, cold pressing and other procedures, to obtain the positive electrode plate.

### [Negative electrode plate]

The negative electrode plate includes a negative-electrode current collector and a negative-electrode film layer arranged on at least one surface of the negative-electrode current collector. The negative-electrode film layer includes a negative-electrode active material.

As an example, the negative electrode current collector has two opposite surfaces in its own thickness direction, and the negative electrode film layer is disposed on either one or both of the two opposite surfaces of the negative electrode current collector.

In some embodiments, the negative electrode current collector may be a metal foil or a composite current collector. For example, a copper foil can be used as the metal foil. The composite current collector may include a high molecular material substrate layer and a metal layer formed on at least one surface of the high molecular material substrate. The composite current collector can be formed by forming a metal material (copper, copper alloy, nickel, nickel alloy, titanium, titanium alloy, silver and silver alloy, etc.) on a high molecular material substrate (such as polypropylene (PP), polyethylene terephthalate (PET), polybutylene terephthalate (PBT), polystyrene (PS), and polyethylene (PE)).

In some embodiments, a negative electrode active material for the battery well known in the art can be used as the negative electrode active material. As an example, the negative electrode active material may include at least one of the following materials: artificial graphite, natural graphite, soft carbon, hard carbon, silicon-based material, tin-based material, and lithium titanate, etc. The silicon-based material may be selected from at least one of elemental silicon, a silicon-oxygen compound, a silicon-carbon composite, a silicon-nitrogen composite, and a silicon alloy. The tin-based material may be selected from at least one of elemental tin, a tin oxide compound, and a tin alloy. However, the present application is not limited to these materials, and other conventional materials useful as negative electrode active materials for batteries can also be used. These negative electrode active materials may be used alone or in combination of two or more thereof.

In some embodiments, the negative electrode film layer further optionally includes a binder. The binder may be selected from at least one of styrene butadiene rubber (SBR), polyacrylic acid (PAA), sodium polyacrylate (PAAS), polyacrylamide (PAM), polyvinyl alcohol (PVA), sodium alginate (SA), polymethacrylic acid (PMAA), and carboxymethyl chitosan (CMCS).

In some embodiments, the negative electrode film layer further optionally includes a conductive agent. The conductive agent may be selected from at least one of superconducting carbon, acetylene black, carbon black, Ketjen black, carbon dot, carbon nanotube, graphene, and carbon nanofiber.

In some embodiments, the negative electrode film layer may further optionally includes other auxiliaries, for example, a thickener (e.g., sodium carboxymethyl cellulose (CMC-Na)).

In some embodiments, the negative electrode plate can be prepared by dispersing the components for preparing the negative electrode plate, for example, the negative electrode active material, the conductive agent, the binder and any other components in a solvent (for example, deionized water) to form a negative electrode slurry; and coating the negative electrode slurry on a negative electrode current collector, followed by oven drying, cold pressing and other procedures, to obtain the negative electrode plate.

### [Electrolyte]

The electrolyte serves to conduct ions between the positive electrode plate and the negative electrode plate. The type of the electrolyte is not particularly limited in the present application, and can be selected according to requirements. For example, the electrolyte may be in a liquid, gel, or full solid state.

In some embodiments, an electrolyte solution is used as the electrolyte. The electrolyte solution comprises an electrolyte salt and a solvent.

In some embodiments, the electrolyte salt may be selected from at least one of lithium hexafluorophosphate, lithium tetrafluoroborate, lithium perchlorate, lithium hexafluoroarsenate, lithium bis(fluorosulfonyl)imide, lithium bis(trifluoromethanesulfonyl)imide, lithium trifluoromethanesulfonate, lithium difluorophosphate, lithium difluoro(oxalato)borate, lithium bis(oxalate)borate, lithium difluoro bis(oxalato)phosphate, and lithium tetrafluoro(oxalato)phosphate.

In some embodiments, the solvent may be selected from at least one of ethylene carbonate, propylene carbonate, ethyl methyl carbonate, diethyl carbonate, dimethyl carbonate, dipropyl carbonate, methyl propyl carbonate, ethyl propyl carbonate, butylene carbonate, fluoroethylene carbonate, methyl formate, methyl acetate, ethyl acetate, propyl acetate, methyl propionate ethyl propionate, propyl propionate, methyl butyrate, ethyl butyrate, 1,4-butyrolactone, sulfolane, dimethyl sulfone, methyl ethyl sulfone and diethyl sulfone.

In some embodiments, the electrolyte solution further optionally comprises an additive. For example, the additive may include a negative electrode film-forming additive, a positive electrode film-forming additive, and may also include additives that can improve certain battery properties, such as additives that improve battery overcharge performance, additives that improve battery high or low temperature performance, and the like.

### [Separator]

In some embodiments, the lithium-ion battery further includes a separator. The type of the separator is not particularly limited in the present application, and any well-known separator with a porous structure having good chemical stability and mechanical stability may be selected.

In some embodiments, the material of the separator may be selected from at least one of glass fiber, non-woven cloth, polyethylene, polypropylene, and polyvinylidene fluoride. The separator may be a single-layer film or a multi-layer composite film, and is not particularly limited. When the separator is a multi-layer composite film, the material of each layer may be the same or different, which is not particularly limited.

In some embodiments, the positive electrode plate, the negative electrode plate, and the separator can be made into an electrode assembly by a winding process or a stacking process.

In some embodiments, the lithium-ion battery may also include an outer package. The outer package can be used to encapsulate the above-mentioned electrode assembly and electrolyte.

In some embodiments, the outer package of the lithium-ion battery can be a hard case, such as a hard plastic case, an aluminum case, a steel case, and the like. The outer package of the lithium-ion battery can also be a soft pack, such as a bag-type soft pack. The material of the soft pack can be a plastic, and examples of the plastic include polypropylene, polybutylene terephthalate and polybutylene succinate, etc.

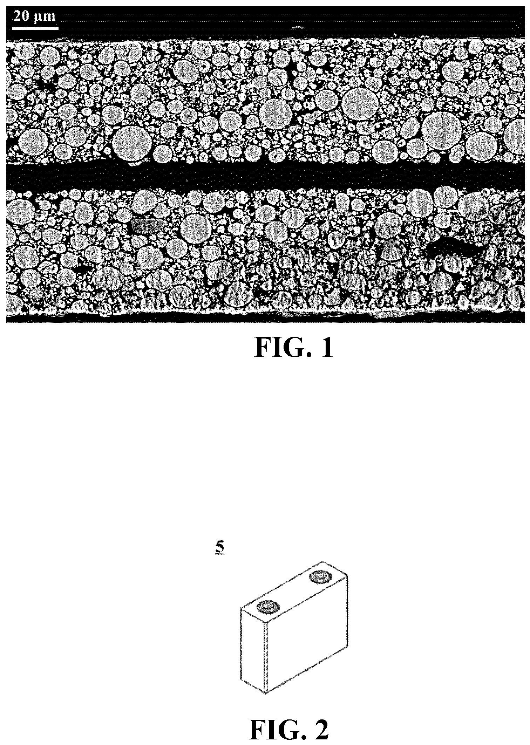

The shape of the lithium-ion battery is not particularly limited in the present application, which may be cylindrical, square or any other shapes. For example, Fig. 2 is a lithium-ion battery 5 of a square structure as an example.

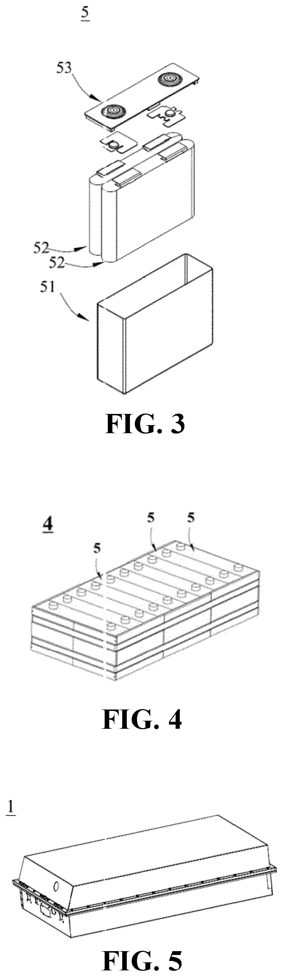

In some embodiments, referring to Fig. 3, the outer package may include a case 51 and a cover plate 53. Here, the case 51 can include a bottom plate and a side plate connected to the bottom plate, with the bottom plate and the side plate enclosing to form an accommodating cavity. The case 51 has an opening that communicates with the accommodating cavity, and the cover plate 53 may cover the opening to close the accommodating cavity. The positive electrode plate, the negative electrode plate, and the separator may be formed into an electrode assembly 52 by a winding process or a stacking process. The electrode assembly 52 is encapsulated within the accommodating cavity. The electrolyte solution impregnates the electrode assembly 52. The number of electrode assemblies 52 contained in the lithium-ion battery 5 may be one or more, which may be selected by those skilled in the art according to specific actual requirements.

In some embodiments, lithium-ion batteries can be assembled into a battery module, the number of lithium-ion batteries contained in the battery module can be one or more, and the specific number can be selected by those skilled in the art according to the application and capacity of the battery module.

Fig. 4 shows a battery module 4 as an example. Referring to Fig. 4, in the battery module 4, a plurality of lithium-ion batteries 5 may be sequentially arranged in a length direction of the battery module 4. Of course, any other arrangement is also possible. The plurality of lithium-ion batteries 5 may further be fixed by fasteners.

Optionally, the battery module 4 may further include a shell having an accommodating space, in which the plurality of lithium-ion batteries 5 are accommodated.

In some embodiments, the battery module may further be assembled into a battery pack, the number of battery module contained in the battery pack may be one or more, and the specific number can be selected by those skilled in the art according to the use and capacity of the battery pack.

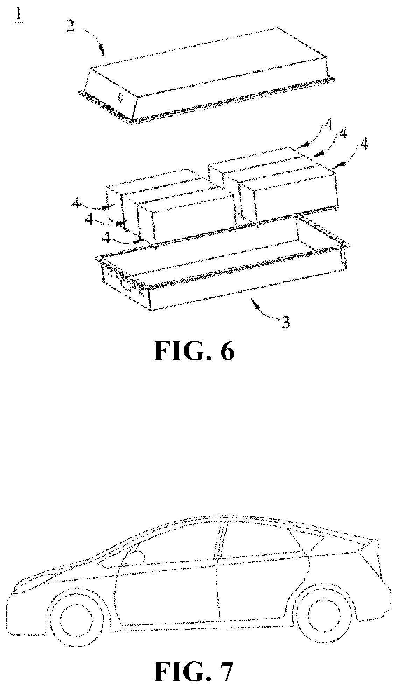

Figs. 5 and 6 show a battery pack 1 as an example. Referring to Figs. 5 and 6, the battery pack 1 may include a battery box and a plurality of battery modules 4 disposed in the battery box. The battery box includes an upper box body 2 and a lower box body 3, the upper box body 2 can cover the lower box body 3 to form a closed space for accommodating the battery modules 4. The plurality of battery modules 4 may be arranged in the battery box in any manner.

In addition, the present application further provides an electrical apparatus, which includes at least one of the lithium-ion battery, the battery module, or the battery pack provided in the present application. The lithium-ion battery, the battery module or the battery pack may be used as a power source for the electrical apparatus or an energy storage unit for the electrical apparatus. The electrical apparatus may include, but is not limited to, a mobile device (such as a mobile phone, and a laptop, etc.), an electric vehicle (such as an all-electric vehicle, a hybrid electric vehicle, a plug-in hybrid electric vehicle, an electric bicycle, an electric scooter, an electric golf cart, and an electric truck, etc.), an electric train, a ship, a satellite, an energy storage system, etc.

For the electrical apparatus, the lithium-ion battery, the battery module, or the battery pack can be selected according to its use requirements.

Fig. 7 shows an electrical apparatus as an example. The electrical apparatus is an all-electric vehicle, a hybrid electric vehicle or a plug-in hybrid electric vehicle, and the like. In order to meet the requirements raised by the electrical apparatus for high power and high energy density of lithium-ion batteries, the battery pack or the battery module may be adopted.

As another example, the device may be a mobile phone, a tablet, a laptop, etc. The device is generally required to be light and thin, and can use a lithium-ion battery as a power source.

### Examples

Examples of the present application will be described hereinafter. The examples described below are exemplary and only used to explain the present application, and are not to be construed as limiting the present application. Where specific techniques or conditions are not specified in the examples, the techniques or conditions described in the literatures of the art or the product specifications are followed. Where manufacturers are not specified, the reagents or instruments used are conventional products and are commercially available. Examples 2 and 5 are Reference Examples

### Example 1

Polycrystalline particles of the first positive electrode active material having a Dv50 of 13 µm, polycrystalline particles of the second positive electrode active material having a Dv50 of 9 µm, and monocrystalline particles of the third positive electrode active material having a Dv50 of 3 µm were sequentially put into agitator tank of 5L according to the ratio of the three masses A, B and C as (A+B):C = 7:3 and A:B = 2.5:7.7, and mixed for 10 minutes, and then sampling was performed to test the SPAN value, Dv99, CPD-1T and BET specific surface area of the mixture. The three positive electrode active material particles used all have the chemical formula LiNi_{0.92}Co_{0.06}Mn_{0.02}O₂.

The conductive agent acetylene black (SP) and the binder polyvinylidene fluoride (PVDF) were then added for a 30 min premix. Finally, the solvent N-methyl pyrrolidone (NMP) was added to carry out rapid stirring under vacuum conditions to form a slurry. The mass ratio of positive electrode active material mixture: acetylene black: polyvinylidene fluoride = 96:2:2, and the solid content of the slurry is 70% by weight. The slurry was uniformly coated on both sides of an aluminum foil with a thickness of 12 µm, and the coated electrode plate was dried in an oven at 100-130°C for half an hour and then taken out. The positive electrode active material load of the electrode plate is 21.5 mg/cm². The taken-out positive electrode plate was rolled and cold-pressed to obtain the data of compacted density, elongation in length direction, pore volume, and shear stress.

Fig. 1 shows a scanning electron microscope image of a positive electrode plate according to Example 1 of the present application. It can be clearly seen from the figure that the positive electrode active material particles have three different sizes, and the gap between the large particles is fully filled with the small particles.

### Comparative Example 1

Polycrystalline particles of the first positive electrode active material having a Dv50 of 11 µm, polycrystalline particles of the second positive electrode active material having a Dv50 of 6.5 µm, and monocrystalline particles of the third positive electrode active material having a Dv50 of 4.5 µm were sequentially put into agitator tank of 5L according to the ratio of the three masses A, B and C as (A+B):C = 3:7. After mixing for 10 minutes, sampling was performed to test the SPAN value, Dv99, CPD-1T and BET specific surface area of the mixture. The three positive electrode active material particles used all have the chemical formula LiNi_{0.92}Co_{0.06}Mn_{0.02}O₂.

The conductive agent acetylene black (SP) and the binder polyvinylidene fluoride (PVDF) were then added for a 30 min premix. Finally, the solvent N-methyl pyrrolidone (NMP) was added to carry out rapid stirring under vacuum conditions to form a slurry. The mass ratio of positive electrode active material mixture: acetylene black: polyvinylidene fluoride = 96:2:2, and the solid content of the slurry is 70% by weight. The slurry was uniformly coated on both sides of an aluminum foil with a thickness of 12 µm, and the coated electrode plate was dried in an oven at 100-130°C for half an hour and then taken out. The positive electrode active material load of the electrode plate is 21.5 mg/cm². The taken-out positive electrode plate was rolled and cold-pressed to obtain the data of compacted density and elongation in length direction.

Examples 3, 4, 6 to 12, Reference Examples 2 and 5, and Comparative Examples 2 to 4

The size and usage amount of polycrystalline particles of the first positive electrode active material, polycrystalline particles of second positive electrode active material and monocrystalline particles of the third positive electrode active material are changed respectively as shown in Table 1, and the positive electrode plates were prepared in the same manner as in Example 1 and then tested.

### Test methods:

### 1. Particle size and amount of positive electrode active material particles

10 regions were randomly selected on the positive electrode plate, and a scanning electron microscope ZEISS Sigma 300 was used, with reference to JY/T010-1996, to obtain a scanning electron microscope (SEM) photograph of each region. In the scanning electron microscope (SEM) photograph, a distance between two points furthest apart on a particle was measured as the particle size.

The particle size was used to determine which positive electrode active material particles belong to in the SEM photograph. The number of each type of particles in each test region was counted through the SEM photograph, an average value of the number of the particles in each test region was calculated as the number of the positive electrode active material particles, and then the ratio of (a+b):c was calculated.

### 2. Compacted density

The compacted density CPD of the positive electrode plate was calculated by the formula CPD = M/(d×A). In the formula, M was the mass of a small wafer with a diameter of 40 mm cut out on the positive electrode plate, which was an average value of mass obtained by weighing 10 times; d was the thickness of the positive electrode plate, which was an average value of thickness obtained by measuring 10 times; and A was the area of the small wafer with a diameter of 40 mm.

### 3. Elongation in length direction

The elongation in length direction of the electrode plate after cold pressing was calculated by the formula ΔEL% = (L2-L1)/L1×100%. In the formula, L1 was the distance between marks before cold pressing, which was 1000 mm, and L2 was the distance between marks after cold pressing. The marks were made by taking three line segments, with a length of 1000 mm, extending in a length direction of the electrode plate at different positions in a width direction of the electrode plate in a central region of the electrode plate, and marking two endpoints of each line segment. L2 was denoted as an average value of the measured distance between the two endpoints of each line segment after cold pressing.

### 4. Pore volume

The pore volume was determined in accordance with GB/T 21650.2-2008/ISO 15901-2: 2006 "Evaluation of Pore Size Distribution and Porosity of Solid Materials by Mercury Porosimetry and Gas Adsorption", Part 2: Analysis of Mesopores and Macropores by Gas Adsorption, using an AccuPyc II 1340 true density tester.

### 5. Shear stress

Cut out a sample with a width of 0.02 m and a length of 0.1 m from an electrode plate to be tested, the edge of the sample having an exposed current collector region for welding of tabs; apply a double-sided tape with a width of 0.02 m and a length of 0.09 m to a steel plate with a width of 0.02 m and a length of 0.2 m, where one end of the double-sided tape is flush with one end of the steel plate; apply the sample to the double-sided tape with one end of the sample flush with one end of the tape; fixing a paper tape with a width of 0.02 m and a length of 0.15 m to the exposed current collector surface of the electrode plate sample; fix the end of the steel plate that is not attached with the electrode plate by a lower fixture of a tensile machine, fold the paper tape upwards and fix it by an upper fixture, turn on the tensile machine to stretch 180° continuously at a speed of 0.05 m/min; and record the maximum load indicated by the tensile machine when the electrode plate breaks, and denote it as the shear stress of the electrode plate.

### 6. Volume-based particle sizes Dv10, Dv50, Dv90 and Dv99

The volume-based particle sizes were determined using an instrument Malvern 3000 in accordance with GB/T 19077-2016/ISO 13320:2009 Particle size analysis - Laser diffraction methods.

### 7. CPD-1T

The CPD-1T was determined using UTM7305 electronic pressure tester in accordance with GB/T 5162-2006 "Graphite Negative Electrode Materials for Lithium-ion Batteries".

### 8. Specific surface area (BET)

The specific surface area was determined using an instrument TriStar II 3020 in accordance with GB/T 19587-2017 "Determination of Specific Surface Area of Solids by Gas Adsorption Using the BET Method".

### 9. TPD

The tap density was determined using a Bettersize BT-300 powder tap density tester in accordance with GB/T 24533-2009 "Metallic Powders - Determination of Tap Density".

Measurement results for each parameter for Examples 1 to 12 and Comparative Examples 1 to 4 are shown in Table 1 below.

**Table 1**

| | First positive electrode active material particles | | Second positive electrode active material particles | | Third positive electrode active material particles | | | (A+ B): C | SPAN of positive electrode active material mixture | Dv99 of positive electrode active material mixture (µm) | CPD-1T of positive electrode active material mixture (g/cm³) | BET specific surface areaof positive electrode active material mixture( m²/g) | (a+ b):c | Por e vol ume (m m³/ g) | Shear stress (MPa ) | Com pacte d densi ty (g/c m³) | Elongati on in length directio n (%) |
|---|---|---|---|---|---|---|---|---|---|---|---|---|---|---|---|---|---|
| | Dv 50( µm) | SPA N | Dv50 (µm) | SPAN | Dv5 0(µ m) | SPA N | TPD( g/cm³ ) | | | | | | | | | | |
| Comparati ve Example 1 | 11 | 1 | 6.5 | 1.35 | 4.5 | 1.4 | 1.45 | 3:7 | 1.6 | 16.5 | 2.89 | 0.716 | 2.7: 7.3 | 3.69 | 0.42 | 3.48 | 0.82 |
| Comparati ve Example 2 | / | / | 9 | 1.35 | 3 | 1.4 | 1.3 | 7:3 | 1.8 | 22.2 | 3.14 | 0.488 | 6.6: 3.4 | 1.74 | 0.62 | 3.62 | 0.85 |
| Comparati ve Example 3 | 11 | 0.6 | 9 | 1.35 | 5.9 | 1.4 | 1.3 | 7:3 | 1.73 | 20.6 | 3.1 | 0.505 | 6.4: 3.6 | 1.78 | 0.58 | 3.57 | 0.83 |
| Comparati ve Example 4 | 11 | 0.9 | 5.5 | 1.4 | 3 | 1.1 | 1.5 | 7:3 | 1.785 | 20.9 | 3.02 | 0.378 | 6.0: 4.0 | 9.81 | 0.5 | 3.51 | 0.90 |
| Example 1 | 13 | 0.6 | 9 | 1.35 | 3 | 1.3 | 1.25 | 7:3 | 1.88 | 20.1 | 3.14 | 0.549 | 6.2: 3.8 | 1.48 | 0.76 | 3.67 | 0.73 |
| Reference Example 2 | 13 | 0.6 | 9 | 1.35 | 3 | 1.3 | 1.25 | 6:4 | 2.15 | 19.9 | 3.2 | 0.662 | 5.7: 4.3 | 1.24 | 0.7 | 3.71 | 0.79 |
| Example 3 | 13 | 0.6 | 9 | 1.35 | 3 | 1.3 | 1.25 | 6.5: 3.5 | 2.05 | 20.5 | 3.19 | 0.627 | 6.1: 3.9 | 1.57 | 0.82 | 3.7 | 0.70 |
| Example 4 | 13 | 0.6 | 9 | 1.35 | 3 | 1.3 | 1.25 | 7.5: 2.5 | 1.76 | 20.9 | 3.11 | 0.597 | 7.2: 2.8 | 1.71 | 0.71 | 3.62 | 0.75 |
| Reference Example 5 | 13 | 0.6 | 9 | 1.35 | 3 | 1.3 | 1.25 | 8:2 | 1.72 | 21 | 3.09 | 0.541 | 7.7: 2.3 | 1.53 | 0.66 | 3.6 | 0.76 |
| Example 6 | 12 | 0.5 | 9 | 1.3 | 3 | 1.1 | 1.25 | 6.5: 3.5 | 1.901 | 20.8 | 3.16 | 0.509 | 6.0: 4.0 | 1.42 | 0.75 | 3.63 | 0.75 |
| Example 7 | 16 | 0.5 | 9 | 1.3 | 3 | 1.1 | 1.25 | 6.5: 3.5 | 2.11 | 20.5 | 3.05 | 0.663 | 6.3: 3.7 | 1.98 | 0.72 | 3.64 | 0.74 |
| Example 8 | 13 | 0.6 | 8 | 1.5 | 3 | 1.3 | 1.25 | 6.5: 3.5 | 1.95 | 20.8 | 3.18 | 0.517 | 6.3: 3.7 | 1.57 | 0.71 | 3.61 | 0.75 |
| Example 9 | 13 | 0.6 | 10 | 1.5 | 3 | 1.3 | 1.25 | 6.5: 3.5 | 1.98 | 19.6 | 3.2 | 0.573 | 6.4: 3.6 | 1.88 | 0.74 | 3.65 | 0.73 |
| Example 10 | 13 | 0.6 | 9 | 1.35 | 2.5 | 1.5 | 1.25 | 6.5: 3.5 | 1.77 | 20.4 | 3.11 | 0.546 | 6.4: 3.6 | 1.64 | 0.73 | 3.66 | 0.73 |
| Example 11 | 13 | 0.6 | 9 | 1.35 | 4 | 1.5 | 1.25 | 6.5: 3.5 | 1.81 | 20.7 | 3.12 | 0.532 | 6.3: 3.7 | 1.28 | 0.69 | 3.55 | 0.78 |
| Example 12 | 13 | 0.6 | 9 | 1.35 | 3 | 1.3 | 1.5 | 6.5: 3.5 | 2.08 | 19.8 | 3.18 | 0.615 | 6.4: 3.6 | 1.33 | 0.8 | 3.72 | 0.79 |

Based on the above results, it can be seen that examples 1-12 all achieve a high compacted density at less than 0.8% elongation in length direction of the electrode plate, allowing a compacted density to be substantially more than 3.6 g/cm³.

In contrast, Comparative Example 2 only used two types of positive electrode active material particles. Although it obtained a compacted density of 3.62 g/cm³, the elongation in length direction of the electrode plate was as high as 0.85%. Although a mixture of two types of polycrystalline particles with a large particle size and monocrystalline particles with a small particle size was also used in Comparative Examples 1, 3 and 4, none of the Dv50 values for the particles fell within the scope of the present application, so that the elongation in length direction of the electrode plate was higher than 0.8% when a high compacted density was obtained. Even if the value of (A+B):C for Comparative Examples 3 and 4 fall within the scope of the present application, a compacted density of more than 3.6 g/cm³ cannot be achieved at an elongation in length direction of the electrode plate that is less than 0.8%.

## Claims

1. A lithium-ion battery positive electrode plate, comprising a positive electrode current collector and a positive electrode film layer disposed on at least one surface of the positive electrode current collector, wherein the positive electrode film layer comprises a positive electrode active material mixture composed of the following materials:
polycrystalline particles of a first positive electrode active material having a Dv50 of 12 to 16 µm and a total mass of A,
polycrystalline particles of a second positive electrode active material having a Dv50 of 8 to 10 µm and a total mass of B, and
monocrystalline particles of a third positive electrode active material having a Dv50 of 2.5 to 4 µm and a total mass of C;
wherein (A+B):C is in the range of 6.5:3.5 to 7.5:2.5; and
wherein Dv50 is measured as described in the description.

2. The positive electrode plate according to claim 1, wherein the polycrystalline particles of the first positive electrode active material, the polycrystalline particles of the second positive electrode active material and the monocrystalline particles of the third positive electrode active material are all ternary positive electrode active materials, optionally, the polycrystalline particles of the first positive electrode active material, the polycrystalline particles of the second positive electrode active material and the monocrystalline particles of the third positive electrode active material each have the same or different chemical composition and all have the chemical formula LiNiₐCo_{b}M_{(1-a-b)}O₂, wherein 0.8 ≤ a < 1.0, 0 < b < 0.2, and a + b < 1.0, and M is selected from one or more of Mn, Al, B, Zr, Sr, Y, Sb, W, Ti, Mg and Nb.

3. The positive electrode plate according to any one of claim 1 or 2, wherein pore volume of the positive electrode film layer is in the range of 1.2 mm³/g to 4.0 mm³/g,
wherein the pore volume is measured as described in the description.

4. The positive electrode plate according to any one of claims 1-3, having a shear stress in the range of 0.65 MPa to 0.85 MPa,
wherein the shear stress is measured in accordance with the description.

5. The positive electrode plate according to any one of claims 1-4, wherein compacted density CPD-1T of the positive electrode active material mixture under 1 ton of pressure is in the range of 3.0g/cm³ to 3.2g/cm³,
wherein the compacted density is measured as described in the description.

6. The positive electrode plate according to any one of claims 1-5, wherein a BET specific surface area of the positive electrode active material mixture is in the range of 0.5 m²/g to 0.7m²/g,
wherein the BET is measured as described in the description.

7. The positive electrode plate according to any one of claims 1-6, wherein a SPAN value of the positive electrode active material mixture is in the range of 1.70 to 2.20, where SPAN = (Dv90-Dv10)/Dv50,
wherein Dv10 and Dv90 are measured as described in the description.

8. The positive electrode plate according to any one of claims 1-7, wherein the positive electrode active material mixture has a Dv99 in the range of 18 µm to 21 µm,
wherein Dv99 is measured as described in the description.

9. The positive electrode plate according to any one of claims 1-8, wherein a SPAN value of the polycrystalline particles of the first positive electrode active material satisfies SPAN ≤ 1.20, optionally, 0.50 ≤ SPAN ≤ 1.00;
and/or
wherein a SPAN value of the polycrystalline particles of the second positive electrode active material satisfies SPAN ≥ 1.20, optionally, 1.30 ≤ SPAN ≤ 1.50.

10. The positive electrode plate according to any one of claims 1-9, wherein a SPAN value of the monocrystalline particles of the third positive electrode active material satisfies SPAN ≤ 1.70, optionally, 1.10 ≤ SPAN ≤ 1.40.

11. The positive electrode plate according to any one of claims 1-10, wherein tap density of the monocrystalline particles of the third positive electrode active material satisfies TPD ≤ 1.8g/cm³, optionally, 1.2g/cm³ ≤ TPD ≤ 1.5g/cm³.

12. A lithium-ion battery (5), comprising the positive electrode plate according to any one of claims 1-11.

13. A battery module (4), comprising the lithium-ion battery (5) of claim 12.

14. A battery pack (1), comprising the battery module (4) of claim 13.

15. An electrical apparatus, comprising at least one selected from the lithium-ion battery (5) of claim 12, the battery module (4) of claim 13, or the battery pack (1) of claim 14.

## Patentansprüche

1. Positive Elektrodenplatte für eine Lithium-Ionen-Batterie, umfassend einen Stromkollektor der positiven Elektrode und eine Filmschicht der positiven Elektrode, die auf mindestens einer Oberfläche des Stromkollektors der positiven Elektrode angeordnet ist, wobei die Filmschicht der positiven Elektrode eine Aktivmaterialmischung der positiven Elektrode umfasst, die aus den folgenden Materialien besteht:
polykristallinen Teilchen eines ersten Aktivmaterials der positiven Elektrode mit einem Dv50 von 12 bis 16 µm und einer Gesamtmasse von A,
polykristallinen Teilchen eines zweiten Aktivmaterials der positiven Elektrode mit einem Dv50 von 8 bis 10 µm und einer Gesamtmasse von B, und
monokristallinen Teilchen eines dritten Aktivmaterials der positiven Elektrode mit einem Dv50 von 2,5 bis 4 µm und einer Gesamtmasse von C;
wobei (A + B):C im Bereich von 6,5:3,5 bis 7,5:2,5 liegt; und
wobei Dv50 wie in der Beschreibung beschrieben gemessen wird.

2. Positive Elektrodenplatte nach Anspruch 1, wobei die polykristallinen Teilchen des ersten Aktivmaterials der positiven Elektrode, die polykristallinen Teilchen des zweiten Aktivmaterials der positiven Elektrode und die monokristallinen Teilchen des dritten Aktivmaterials der positiven Elektrode allesamt ternäre Aktivmaterialien der positiven Elektrode sind, wobei optional die polykristallinen Teilchen des ersten Aktivmaterials der positiven Elektrode, die polykristallinen Teilchen des zweiten Aktivmaterials der positiven Elektrode und die monokristallinen Teilchen des dritten Aktivmaterials der positiven Elektrode jeweils die gleiche oder eine unterschiedliche chemische Zusammensetzung aufweisen und allesamt die chemische Formel LiNiₐCo_{b}M_{(1-a-b)}O₂ aufweisen, wobei 0,8 ≤ a < 1,0, 0 < b < 0,2 und a + b < 1,0, und M aus einem oder mehreren von Mn, Al, B, Zr, Sr, Y, Sb, W, Ti, Mg und Nb ausgewählt ist.

3. Positive Elektrodenplatte nach einem der Ansprüche 1 oder 2, wobei das Porenvolumen der Filmschicht der positiven Elektrode im Bereich von 1,2 mm³/g bis 4,0 mm³/g liegt,
wobei das Porenvolumen wie in der Beschreibung beschrieben gemessen wird.

4. Positive Elektrodenplatte nach einem der Ansprüche 1-3 mit einer Scherspannung im Bereich von 0,65 MPa bis 0,85 MPa,
wobei die Scherspannung gemäß der Beschreibung gemessen wird.

5. Positive Elektrodenplatte nach einem der Ansprüche 1-4, wobei die kompaktierte Dichte CPD-1T der Aktivmaterialmischung der positiven Elektrode unter 1 Tonne Druck im Bereich von 3,0 g/cm³ bis 3,2 g/cm³ liegt,
wobei die kompaktierte Dichte wie in der Beschreibung beschrieben gemessen wird.

6. Positive Elektrodenplatte nach einem der Ansprüche 1-5, wobei eine BET-spezifische Oberfläche der Aktivmaterialmischung der positiven Elektrode im Bereich von 0,5 m²/g bis 0,7m²/g liegt,
wobei BET wie in der Beschreibung beschrieben gemessen wird.

7. Positive Elektrodenplatte nach einem der Ansprüche 1-6, wobei ein SPAN-Wert der Aktivmaterialmischung der positiven Elektrode im Bereich von 1,70 bis 2,20 liegt, wobei SPAN = (Dv90 - Dv10)/Dv50,
wobei Dv10 und Dv90 wie in der Beschreibung beschrieben gemessen werden.

8. Positive Elektrodenplatte nach einem der Ansprüche 1-7, wobei die Aktivmaterialmischung der positiven Elektrode einen Dv99 im Bereich von 18 µm bis 21 µm aufweist,
wobei Dv99 wie in der Beschreibung beschrieben gemessen wird.

9. Positive Elektrodenplatte nach einem der Ansprüche 1-8, wobei ein SPAN-Wert der polykristallinen Teilchen des ersten Aktivmaterials der positiven Elektrode SPAN ≤ 1,20, optional 0,50 ≤ SPAN ≤ 1,00, erfüllt;
und/oder
wobei ein SPAN-Wert der polykristallinen Teilchen des zweiten Aktivmaterials der positiven Elektrode SPAN ≥ 1,20, optional 1,30 ≤ SPAN ≤ 1,50, erfüllt.

10. Positive Elektrodenplatte nach einem der Ansprüche 1-9, wobei ein SPAN-Wert der monokristallinen Teilchen des dritten Aktivmaterials der positiven Elektrode SPAN ≤ 1,70, optional 1,10 ≤ SPAN ≤ 1,40, erfüllt.

11. Positive Elektrodenplatte nach einem der Ansprüche 1-10, wobei die Klopfdichte der monokristallinen Teilchen des dritten Aktivmaterials der positiven Elektrode TPD ≤ 1,8 g/cm³, optional 1,2 g/cm³ ≤ TPD ≤ 1,5 g/cm³, erfüllt.

12. Lithium-Ionen-Batterie (5), umfassend die positive Elektrodenplatte nach einem der Ansprüche 1-11.

13. Batteriemodul (4), umfassend die Lithium-Ionen-Batterie (5) nach Anspruch 12.

14. Batteriepackung (1), umfassend das Batteriemodul (4) nach Anspruch 13.

15. Elektrische Einrichtung, die mindestens eines umfasst, das aus der Lithium-Ionen-Batterie (5) nach Anspruch 12, dem Batteriemodul (4) nach Anspruch 13 oder der Batteriepackung (1) nach Anspruch 14 ausgewählt ist.

## Revendications

1. Plaque d'électrode positive de batterie lithium-ion, comprenant un collecteur de courant d'électrode positive et une couche de film d'électrode positive disposée sur au moins une surface du collecteur de courant d'électrode positive, la couche de film d'électrode positive comprenant un mélange de matériaux actifs d'électrode positive composé des matériaux suivants :
des particules polycristallines d'un premier matériau actif d'électrode positive ayant un Dv50 de 12 à 16 µm et une masse totale A,
des particules polycristallines d'un deuxième matériau actif d'électrode positive ayant un Dv50 de 8 à 10 µm et une masse totale B, et
des particules monocristallines d'un troisième matériau actif d'électrode positive ayant un Dv50 de 2,5 à 4 µm et une masse totale C ;
dans laquelle (A+B):C est compris entre 6,5:3,5 et 7,5:2,5 ; et
dans laquelle Dv50 est mesuré comme le décrit la description.

2. Plaque d'électrode positive selon la revendication 1, dans laquelle les particules polycristallines du premier matériau actif d'électrode positive, les particules polycristallines du deuxième matériau actif d'électrode positive et les particules monocristallines du troisième matériau actif d'électrode positive sont toutes des matériaux actifs d'électrode positive ternaires, éventuellement les particules polycristallines du premier matériau actif d'électrode positive, les particules polycristallines du deuxième matériau actif d'électrode positive et les particules monocristallines du troisième matériau actif d'électrode positive ont une composition chimique identique ou différente et répondent toutes à la formule chimique LiNiₐCo_{b}M_{(1-a-b)}O₂ dans laquelle 0,8 ≤ a < 1,0, 0 < b < 0,2 et a + b < 1,0, et M est choisi à partir d'un ou plusieurs éléments parmi Mn, Al, B, Zr, Sr, Y, Sb, W, Ti, Mg et Nb.

3. Plaque d'électrode positive selon l'une quelconque des revendications 1 et 2, dans laquelle le volume de pores de la couche de film d'électrode positive est compris entre 1,2 mm³/g et 4,0 mm³/g,
le volume de pores étant mesuré comme le décrit la description.

4. Plaque d'électrode positive selon l'une quelconque des revendications 1 à 3, présentant une contrainte de cisaillement comprise entre 0,65 MPa et 0,85 MPa,
la contrainte de cisaillement étant mesurée conformément à la description.

5. Plaque d'électrode positive selon l'une quelconque des revendications 1 à 4, dans laquelle la masse volumique après tassement CPD-1T du mélange de matériaux actifs d'électrode positive sous 1 tonne de pression est comprise entre 3,0 g/cm³ et 3,2 g/cm³,
la masse volumique après tassement étant mesurée comme le décrit la description.

6. Plaque d'électrode positive selon l'une quelconque des revendications 1 à 5, dans laquelle la surface spécifique BET du mélange de matériaux actifs d'électrode positive est comprise entre 0,5 m²/g et 0,7 m²/g,
la BET étant mesurée comme le décrit la description.

7. Plaque d'électrode positive selon l'une quelconque des revendications 1 à 6, dans laquelle une valeur d'étendue du mélange de matériaux actifs d'électrode positive est comprise entre 1,70 et 2,20, où étendue = (Dv90-Dv10)/Dv50,
Dv10 et Dv90 étant mesurés comme le décrit la description.

8. Plaque d'électrode positive selon l'une quelconque des revendications 1 à 7, dans laquelle le mélange de matériaux actifs d'électrode positive a un Dv99 compris entre 18 µm et 21 µm,
Dv99 étant mesuré comme le décrit la description.

9. Plaque d'électrode positive selon l'une quelconque des revendications 1 à 8, dans laquelle une valeur d'étendue des particules polycristallines du premier matériau actif d'électrode positive satisfait étendue ≤ 1,20, éventuellement 0,50 ≤ étendue ≤ 1,00 ;
et/ou
dans laquelle une valeur d'étendue des particules polycristallines du deuxième matériau actif d'électrode positive satisfait étendue ≥ 1,20, éventuellement 1,30 ≤ étendue ≤ 1,50.

10. Plaque d'électrode positive selon l'une quelconque des revendications 1 à 9, dans laquelle une valeur d'étendue des particules monocristallines du troisième matériau actif d'électrode positive satisfait étendue ≤ 1,70, éventuellement 1,10 ≤ étendue ≤ 1,40.

11. Plaque d'électrode positive selon l'une quelconque des revendications 1 à 10, dans laquelle la masse volumique après tassement des particules monocristallines du troisième matériau actif d'électrode positive satisfait TPD ≤ 1,8 g/cm³, éventuellement 1,2 g/cm³ ≤ TPD ≤ 1,5 g/cm³.

12. Batterie lithium-ion (5), comprenant la plaque d'électrode positive selon l'une quelconque des revendications 1 à 11.

13. Module de batterie (4), comprenant la batterie lithium-ion (5) de la revendication 12.

14. Bloc-batterie (1), comprenant le module de batterie (4) de la revendication 13.

15. Appareil électrique, comprenant au moins un élément choisi parmi la batterie lithium-ion (5) de la revendication 12, le module de batterie (4) de la revendication 13 et le bloc-batterie (1) de la revendication 14.
